(19) Europäisches Patentamt
European Patent Office
Office européen des brevets

(11) **EP 3 353 798 B1**

(12) **EUROPÄISCHE PATENTSCHRIFT**

(45) Veröffentlichungstag und Bekanntmachung des Hinweises auf die Patenterteilung:
**25.03.2020 Patentblatt 2020/13**

(21) Anmeldenummer: **16798077.0**

(22) Anmeldetag: **15.09.2016**

(51) Int Cl.:
*H01F 7/18* (2006.01)          *G01R 31/327* (2006.01)
*F16K 37/00* (2006.01)

(86) Internationale Anmeldenummer:
**PCT/DE2016/200433**

(87) Internationale Veröffentlichungsnummer:
**WO 2017/050331 (30.03.2017 Gazette 2017/13)**

(54) **STEUERUNGSEINHEIT SOWIE VERFAHREN ZUM ÜBERWACHEN DER FUNKTION EINES ELEKTROMAGNETISCHEN AKTUATORS**

CONTROL UNIT AND METHOD FOR MONITORING THE FUNCTION OF AN ELECTROMAGNETIC ACTUATOR

UNITÉ DE COMMANDE AINSI QUE PROCÉDÉ DE SURVEILLANCE DU FONCTIONNEMENT D'UN ACTIONNEUR ÉLECTROMAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.09.2015 DE 102015218091**

(43) Veröffentlichungstag der Anmeldung:
**01.08.2018 Patentblatt 2018/31**

(73) Patentinhaber: **Schaeffler Technologies AG & Co. KG**
**91074 Herzogenaurach (DE)**

(72) Erfinder:
• **WANG, Weigang**
  **90489 Nürnberg (DE)**
• **TRAVERSA, Piergiacomo**
  **90587 Tuchenbach (DE)**
• **ELICKER, Michael**
  **91325 Adelsdorf (DE)**

(56) Entgegenhaltungen:
**DE-A1- 10 232 358     DE-A1-102014 203 686**
**US-A- 5 548 210**

**Beschreibung**

Die vorliegende Erfindung betrifft zunächst ein Verfahren zum Überwachen der Funktion eines elektromagnetischen Aktuators. Bei dem elektromagnetischen Aktuator kann es sich beispielsweise um ein Schaltventil handeln. Die Funktion des elektromagnetischen Aktuators kann insbesondere dadurch gestört sein, dass der elektromagnetische Aktuator blockiert ist. Die Erfindung betrifft weiterhin eine Steuerungseinheit zur Steuerung und Überwachung eines elektromagnetischen Aktuators.

Die US 2011/0163769 A1 zeigt ein Verfahren zum Erkennen mindestens einer mittleren Hubposition einer durch ein aktives Materialelement angetriebenen Last. In dieser mittleren Hubposition erfährt das Materialelement eine Belastungsänderung.

Aus der US 2005/0146408 A1 ist ein Verfahren zum Erkennen des Erreichens einer Verschlussposition eines elektromagnetischen Schaltventiles bekannt, bei welchem der nach einer Deaktivierung des Schaltventiles fließende Strom ausgewertet wird. Die DE 10 2013 213 329 A1 lehrt ein Verfahren zum Erkennen der Funktionsweise eines Schaltventiles, welches einen in einer Spule verlaufenden Magnetkern und einen Ventilkörper umfasst, der mithilfe des Magnetkernes und der bestromten Spule in axialer Richtung bewegt wird. Bei diesem Verfahren wird ein in der nicht bestromten Spule durch den Magnetkern induzierter Stromverlauf erfasst. Der induzierte Stromverlauf wird hinsichtlich Schwingungsform oder Höhe des induzierten Stromes ausgewertet. Aus der DE10 2014 203686 A1 ist ein Verfahren zum Detektieren eines Betriebszustand eines elektromagnetischen Aktors bekannt.

Die Aufgabe der vorliegenden Erfindung besteht ausgehend vom Stand der Technik darin, die Funktion eines elektromagnetischen Aktuators genauer überwachen zu können, um insbesondere Blockaden des elektromagnetischen Aktuators sicherer erkennen zu können.

Die genannte Aufgabe wird gelöst durch einen elektromagnetischen Aktuator gemäß dem beigefügten Anspruch 1 sowie durch eine Steuerungseinheit gemäß dem beigefügten nebengeordneten Anspruch 8.

Das erfindungsgemäße Verfahren dient zum Überwachen der Funktion eines elektromagnetischen Aktuators. Bei dem elektromagnetischen Aktuator handelt es sich bevorzugt um ein Schaltventil, welches beispielsweise in einem Automobil, in einer chemischen Anlage, in einer energietechnischen Anlage, in einer Maschine oder in einer medizintechnischen Anlage Verwendung findet. Das Schaltventil kann insbesondere für einen Verbrennungsmotor eines Kraftfahrzeuges ausgebildet sein. Bei dem elektromagnetischen Aktuator kann es sich aber auch beispielsweise um einen Hubmagneten handeln. Mit dem erfindungsgemäßen Verfahren wird die korrekte Funktion des elektromagnetischen Aktuators überwacht, sodass mögliche Fehler und/oder Defekte des Aktuators und mögliche Fehler und/oder Defekte eines durch den Aktuator angetriebenen Elementes erkannt werden können. Insbesondere sind mit dem erfindungsgemäßen Verfahren mechanische Blockaden des Aktuators erkennbar.

Der elektromagnetische Aktuator umfasst einen Magnetkern und eine elektrische Spule, in deren Inneren bevorzugt der Magnetkern angeordnet ist. Der Magnetkern ist durch Bestromung der elektrischen Spule verschiebbar, sodass elektrische Energie in mechanische Energie umgewandelt wird und der elektromagnetische Aktuator das von ihm zu bewegende Element antreibt. Der Magnetkern ist in der elektrischen Spule bevorzugt in axialer Richtung der elektrischen Spule verschiebbar. Am Magnetkern ist ein Aktuatorelement angebracht, welches durch den Magnetkern verschoben wird. Bei dem Aktuatorelement handelt es sich bevorzugt um einen Ventilkörper, wenn der Aktuator durch ein Schaltventil gebildet ist.

In einem Schritt des erfindungsgemäßen Verfahrens erfolgt ein Messen eines sich zeitlich verändernden, durch die elektrische Spule fließenden Stromes. Dieses Messen erfolgt insbesondere während der Bestromung der elektrischen Spule und/oder nach der Bestromung der elektrischen Spule.

In einem weiteren Schritt des erfindungsgemäßen Verfahrens erfolgt ein Auswählen mindestens eines zeitlichen Bewertungsabschnittes des Verlaufes des gemessenen Stromes. In diesem Bewertungsabschnittes ändert sich der Strom von einem Abschnittsanfangsstromwert la auf einen Abschnittsendstromwert $I_b$, wobei diese Änderung monoton erfolgt. Die monotone Änderung kann durch eine monotone Steigung oder durch einen monotonen Abfall gebildet sein. Die monotone Änderung kann durch vernachlässigbare Schwankungen des Stromes unterbrochen sein. Der zeitliche Bewertungsabschnitt dauert eine Abschnittszeitdauer $t_{ab}$. Bevorzugt ändert sich der Strom im Bewertungsabschnitt monoton vom Abschnittsanfangsstromwert $I_a$ über einen Abschnittszwischenstromwert $I_d$ auf den Abschnittsendstromwert $I_b$. Bis zum Auftreten des Abschnittszwischenstromwertes $I_d$ vergeht eine Zwischenabschnittszeitdauer $t_{ad}$.

In einem weiteren Schritt des erfindungsgemäßen Verfahrens wird ein Bewertungsprodukt aus Faktoren gebildet, welche zumindest einerseits den Abschnittsanfangsstromwert $I_a$ und den Abschnittsendstromwert $I_b$ sowie andererseits die Abschnittszeitdauer $t_{ab}$ umfassen. Folglich umfasst mindestens einer der Faktoren den Abschnittsanfangsstromwert $I_a$ und/oder den Abschnittsendstromwert $I_b$ und mindestens ein anderer der Faktoren die Abschnittszeitdauer $t_{ab}$. Sowohl der Abschnittsanfangsstromwert $I_a$, als auch der Abschnittsendstromwert $I_b$ gehen in das Produkt ein. Das Produkt kann Teilprodukte als Summanden umfassen. Jedenfalls weist das Bewertungsprodukt Strom als eine erste Dimension und Zeit als eine zweite Dimension auf. Bevorzugt wird das Bewertungsprodukt aus Faktoren gebildet, welche zumindest einerseits den Abschnittsanfangsstromwert $I_a$, den Abschnittszwischenstromwert $I_d$ und den Ab-

schnittsendstromwert $I_b$ sowie andererseits die Abschnittszeitdauer $t_{ab}$ und die Zwischenabschnittszeitdauer $t_{ad}$ umfassen.

Erfindungsgemäß wird eine Fehlfunktion des Aktuators durch Vergleichen des Bewertungsproduktes mit einer Bewertungsproduktgrenze erkannt. Die Fehlfunktion des elektromagnetischen Aktuators ist insbesondere durch eine Blockierung des elektromagnetischen Aktuators gegeben, bei welcher der Magnetkern daran gehindert ist, verschoben zu werden. Die Erfindung beruht auf der überraschenden Erkenntnis, dass Produkte, welche aus Zeiten und Amplituden des Verlaufes des gemessenen Stromes gebildet sind, sich signifikant ändern, wenn der Aktuator blockiert ist.

Die erkannte Fehlfunktion wird bevorzugt ausgegeben, beispielsweise durch eine Steuerungseinheit zum Steuern und Überwachen des Aktuators, welche die Fehlfunktion an ein übergeordnetes System zur Steuerung eines Verbrennungsmotors meldet.

Ein besonderer Vorteil des erfindungsgemäßen Verfahrens besteht darin, dass es eine sichere Überwachung von elektromagnetischen Aktuatoren während ihres Betriebes ermöglicht und dadurch Schäden infolge eines blockierten Aktuators vermieden werden können. Beispielsweise können durch elektromagnetische Aktuatoren in Form von Schaltventilen in einem Verbrennungsmotor eines Kraftfahrzeuges erhebliche Schäden verursacht werden, wenn eines der Schaltventile wegen eines Defektes blockiert ist. Es kann insbesondere zu einer unbeabsichtigten Verlangsamung des Kraftfahrzeuges, zu einem suboptimalen Treibstoff-Luft-Verhältnis, zu Schädigungen durch im Verbrennungsmotor unverbrannten Treibstoff oder zu Totalschäden des Verbrennungsmotors infolge von nicht geschlossenen Ventilen im Verbrennungsraum kommen. Derartige Schäden können mit dem erfindungsgemäßen Verfahren verhindert werden.

Die Blockierung eines Schaltventiles stellt einen typischen Fehler dar. Eine solche Blockierung kann auf verschiedene Ursachen zurückzuführen sein; auf einen Produktionsfehler, auf eine geringe Verarbeitungsqualität, auf eine unzureichende Schmierung während des Betriebes, auf extreme Temperaturbedingungen, auf eine fehlerhafte Bestromung oder auf Abnutzungserscheinungen.

Im elektromagnetischen Aktuator wird elektrische Energie in mechanische Energie gewandelt. Der durch die elektrische Spule fließende Strom ergibt sich aus einem Ausgleich verschiedener Energien, nämlich einer elektrischen Energie, einer magnetischen Energie, einer kinetischen Energie, einer Arbeit gegen eine im Aktuator wirkende Feder und thermischen Verlusten. Die vorliegende Erfindung nutzt den Ausgleich zwischen der elektrischen Energie und der magnetischen Energie, um eine Blockierung des Aktuators erkennen zu können.

Bei bevorzugten Ausführungsformen des erfindungsgemäßen Verfahrens repräsentiert das Bewertungsprodukt einen Flächeninhalt einer Fläche an einem Funktionsgraphen des zeitlich veränderlichen Stromes. Der Funktionsgraph ist in einem kartesischen Koordinatensystem angeordnet. Die Fläche wird zumindest in zwei Punkten durch den Funktionsgraphen begrenzt. Die Fläche wird zumindest durch einen dem Abschnittsanfangsstromwert zugeordneten Punkt des Funktionsgraphen und durch einen dem Abschnittsendstromwert zugeordneten Punkt des Funktionsgraphen begrenzt.

Die beschriebene Fläche wird bevorzugt durch eine durch den dem Abschnittsanfangsstromwert zugeordneten Punkt des Funktionsgraphen laufende erste Gerade begrenzt. Die erste Gerade verläuft parallel zu einer der Zeit zugeordneten Achse des Koordinatensystems oder zu einer dem Strom zugeordneten Achse des Koordinatensystems.

Die beschriebene Fläche wird bevorzugt durch eine durch den dem Abschnittsendstromwert zugeordneten Punkt des Funktionsgraphen laufende zweite Gerade begrenzt. Die zweite Gerade verläuft parallel zu der der Zeit zugeordneten Achse des Koordinatensystems oder zu der dem Strom zugeordneten Achse des Koordinatensystems.

Die erste Gerade und die zweite Gerade sind bevorzugt senkrecht zueinander ausgerichtet. Bevorzugt ist eine der beiden Geraden parallel zu der der Zeit zugeordneten Achse des Koordinatensystems ausgerichtet, während die andere der beiden Geraden zu der dem Strom zugeordneten Achse des Koordinatensystems ausgerichtet ist. Je nachdem, welche der beiden Geraden parallel zu der der Zeit zugeordneten Achse des Koordinatensystems ausgerichtet ist, befindet sich die Fläche oberhalb oder unterhalb des im Koordinatensystem dargestellten Funktionsgraphen.

Bei bevorzugten Ausführungsformen des erfindungsgemäßen Verfahrens wird ein dem Bewertungsabschnitt zugeordneter Teil des Funktionsgraphen in einem ersten Bewertungsteilabschnitt durch eine dritte Gerade approximiert, während er in einem zweiten Bewertungsteilabschnitt durch eine vierte Gerade approximiert wird. Der ersten Bewertungsteilabschnitt und der zweite Bewertungsteilabschnitt folgen unmittelbar aufeinander. Der erste Bewertungsteilabschnitt beginnt gleichzeitig mit dem Bewertungsabschnitt, während der zweite Bewertungsteilabschnitt gleichzeitig mit dem Bewertungsabschnitt endet. Die Approximation des dem Bewertungsabschnitt zugeordneten Teiles des Funktionsgraphen durch zwei Geraden senkt den Rechenaufwand zur Bestimmung des Bewertungsproduktes. Die zwei Geraden stellen eine gute Näherung für typische Bewertungsabschnitte des Verlaufes des durch die Spule des Aktuators fließenden Stromes dar.

Die oben beschriebene Fläche ist bevorzugt durch ein Viereck gebildet, dessen vier Seiten durch die erste Gerade, durch die zweite Gerade, durch die dritte Gerade und durch die vierte Gerade gebildet sind. Das Viereck weist bevorzugt einen rechten Winkel auf, der von der ersten Gerade und der zweiten Gerade aufgespannt wird. Der Flächeninhalt dieses Viereckes ist aufwandsarm bestimmbar.

Die oben beschriebene Fläche ist bevorzugt durch ein rechtwinkliges Dreieck mit einer nicht geraden Hypotenuse gebildet. Das Dreieck ist bevorzugt durch seine Hypotenuse konkav ausgebildet. Die Katheten des Dreiecks sind durch die erste Gerade und durch die zweite Gerade gebildet. Die Hypotenuse ist bevorzugt durch den dem Bewertungsabschnitt zugeordneten Teil des Funktionsgraphen gebildet. Die Hypotenuse ist alternativ bevorzugt gemeinsam durch die dritte und vierte Gerade gebildet. Entsprechend ist das Bewertungsprodukt als ein Dreiecksoperator $\Delta$ auffassbar. Der Dreiecksoperator $\Delta$ ist ein an dem durch die elektrische Spule fließenden Strom erkennbarer Indikator für einen energetischen Ausgleich zwischen elektrischer Energie, magnetischer Energie und kinetischer Energie im Bewertungsabschnitt.

Bei bevorzugten Ausführungsformen des erfindungsgemäßen Verfahrens wird durch den auf dem Funktionsgraphen liegenden Schnittpunkt zwischen der dritten Gerade und der vierten Gerade der Abschnittszwischenstromwert $I_d$ repräsentiert.

Bei bevorzugten Ausführungsformen des erfindungsgemäßen Verfahrens umfasst das Bewertungsprodukt als einen weiteren Faktor einen Spannungswert einer zum Bestromen der elektrischen Spule an die elektrische Spule angelegten Betriebsspannung V. Auf diesen Faktor kann insbesondere verzichtet werden, wenn die Spannung V konstant ist.

Der gemessene Strom steigt während einer Stromanstiegsphase an. Die Stromanstiegsphase liegt in einer frühen zeitlichen Phase der Bestromung. Im Verlauf der Stromanstiegsphase befindet sich der Magnetkern zunächst im Leerlauf. An den zeitlichen Abschnitt des Leerlaufes schließt sich ein zeitlicher Abschnitt der magnetischen Sättigung an, welcher ebenfalls in der Stromanstiegsphase liegt. Die Stromanstiegsphase dauert bevorzugt zwischen 0,1 ms und 10 ms; besonders bevorzugt zwischen 1 ms und 3 ms.

Die Stromanstiegsphase beginnt nachdem die Betriebsspannung V an die elektrische Spule angelegt wurde, um die elektrische Spule zu bestromen. Nachdem die Betriebsspannung V an die elektrische Spule angelegt wurde, beginnt die Stromanstiegsphase mit oder ohne eine kurze zeitliche Verzögerung.

Der durch die elektrische Spule fließende Strom steigt während der Stromanstiegsphase bevorzugt von einem Minimalstromwert bis zu einem Maximalstromwert an. Diesem Steigen des Stromes kann ein geringer Wechselstromanteil überlagert sein. Beim Erreichen des Maximalstromwertes ist eine magnetische Sättigung des elektromagnetischen Aktuators erfolgt.

Bei dem erfindungsgemäßen Verfahren schließt sich an die Stromanstiegsphase eine Spitzenstromphase an, in welcher der Strom von einem Spitzenstromphasenanfangswert auf einen Spitzenstromphasenzwischenwert sinkt und vom Spitzenstromphasenzwischenwert auf einen Spitzenstromphasenendwert steigt. Diesem Sinken und Steigen des Stromes kann ein geringer Wechselstromanteil überlagert sein.

Bei dem erfindungsgemäßen Verfahren schließt sich an die Spitzenstromphase eine Haltestromphase an, in welcher der gemessene Strom bis in einen Haltstromwertbereich sinkt und dort verbleibt.

Bei dem erfindungsgemäßen Verfahren liegt zeitlich nach der Spitzenstromphase eine Auslaufphase, welche sich insbesondere an die Haltestromphase anschließt. Der zeitliche Beginn der Auslaufphase ist dadurch gegeben, dass die Betriebsspannung wieder von der elektrischen Spule genommen wurde; d. h. dass der elektromagnetische Aktuator abgeschaltet wurde. Während der Auslaufphase steigt der gemessene Strom von einem Auslaufphasenanfangsstromwert auf einen Auslaufphasenzwischenstromwert, woraufhin er vom Auslaufphasenzwischenstromwert auf einen Auslaufphasenendstromwert sinkt. Der Auslaufphasenendstromwert ist bevorzugt Null.

Der Magnetkern befindet sich während der Stromanstiegsphase bevorzugt einen überwiegenden Teil der Stromanstiegsphase im Leerlauf; zumindest wenn der elektromagnetische Aktuator fehlerfrei funktioniert.

Bei dem erfindungsgemäßen Verfahren liegt einer Bewertungsabschnitt innerhalb der Stromanstiegsphase.

Der Abschnittsanfangsstromwert ist zu einem Abweichungszeitpunkt gegeben. Der Abweichungszeitpunkt wird durch die folgenden Teilschritte bestimmt. In einem Teilschritt wird eine Logarithmusfunktion des in der Stromanstiegsphase gemessenen Stromes gebildet. Somit umfasst das Argument der Logarithmusfunktion den zeitlich veränderlichen Strom. Entsprechend ist die Logarithmusfunktion von der Zeit abhängig. In einem weiteren Teilschritt erfolgt ein Approximieren der einen frühen zeitlichen Teilabschnitt des Leerlaufes repräsentierenden Logarithmusfunktion durch eine Linearfunktion. Diese Approximation ist möglich, da der Strom in der Stromanstiegsphase nahezu logarithmisch steigt, solang sich der Magnetkern im Leerlauf befindet. Im Ergebnis dieses Teilschrittes liegt die Linearfunktion vor, welche den zeitlichen Verlauf der Logarithmusfunktion des gemessenen Stromes während des frühen zeitlichen Teilabschnittes des Leerlaufes mit großer Genauigkeit wiedergibt. Es erfolgt zudem ein laufendes Bestimmen einer Differenz zwischen der Logarithmusfunktion und der Linearfunktion über den frühen zeitlichen Teilabschnitt des Leerlaufes hinaus und ggf. bis zum Ende der Stromanstiegsphase. Die Differenz wird ggf. bereits während des frühen zeitlichen Teilabschnittes des Leerlaufes bestimmt. Die Differenz ist während des frühen zeitlichen Teilabschnittes des Leerlaufes sehr klein, da die Logarithmusfunktion in diesem Teilabschnitt nahezu linear verläuft. Nach dem frühen zeitlichen Teilabschnittes des Leerlaufes wird die Differenz zunehmend größer und steigt insbesondere zum Ende des zeitlichen Abschnittes des Leerlaufes signifikant an. Entsprechend wird der Abweichungszeitpunkt ausgehend davon ermittelt, wann die Differenz ein vorab definiertes Differenzmaß erreicht bzw. übersteigt. Der Abweichungszeitpunkt beschreibt den Zeitpunkt, ab wann der zeitliche Verlauf des gemessenen Stromes nicht mehr logarithmisch ist, was durch eine einsetzende magnetische Sättigung bedingt ist. Bevorzugt weist der gemessene Strom im Argument der Logarithmusfunktion ein negatives Vorzeichen auf. Folglich sinkt die Logarithmusfunktion mit der Zeit. Bevorzugt wird der gemessene Strom im Argument der Logarithmusfunktion von dem Maximalstromwert subtrahiert. Dabei umfasst das Argument der Logarithmusfunktion bevorzugt eine positive Konstante als Summand, um zu garantieren, dass das Argument größer als Null ist. Bei der Logarithmusfunktion handelt es sich bevorzugt um einen dekadischen Logarithmus, wobei die Logarithmusfunktion auch eine andere Basis besitzen kann.Die Logarithmusfunktion, die nachfolgend mit dem Formelzeichen $f_{i\_log}(t)$ bezeichnet wird, ist bevorzugt durch die folgende Formel definiert:

$$f_{i\_log}(t) = \log[I_{max} - i(t) + c]$$

In dieser Formel steht $i(t)$ für den gemessenen Strom in der Stromanstiegsphase. Imax steht für den Maximalstromwert. Das Formelzeichen $c$ steht für die positive Konstante. Bevorzugt erfolgt das Approximieren durch eine lineare Approximation der den frühen zeitlichen Abschnitt des Leerlaufes repräsentierenden Logarithmusfunktion. Es sind verschiedene Methoden zur linearen Approximation bekannt und etabliert. Das Ende des frühen zeitlichen Abschnittes des Leerlaufes kann durch Messungen vorab definiert werden. Bevorzugt wird das Ende des frühen zeitlichen Abschnittes des Leerlaufes aber dann definiert, wenn ein Approximationsfehler der linearen Approximation ein vorab festgelegtes maximales Approximationsfehlermaß übersteigt.

Das Ermitteln des Abweichungszeitpunktes erfolgt am einfachsten dadurch, dass der Zeitpunkt, in welchem die Differenz das vorab definierte Differenzmaß erreicht, als Abweichungszeitpunkt verwendet wird. Bevorzugt erfolgt das Ermitteln des Abweichungszeitpunktes dadurch, dass der Zeitpunkt, in welchem die Differenz das vorab definierte Differenzmaß erreicht, um eine Kalibrierungszeitdauer verringert wird und als Abweichungszeitpunkt verwendet wird. Die Kalibrierungszeitdauer wird bevorzugt vorab durch Messungen am elektromagnetischen Aktuator bestimmt.

Bei dem erfindungsgemäßen Verfahren ist der Abschnittsendstromwert $I_b$ kleiner als der Maximalstromwert und liegt somit zeitlich vor dem Ende der Stromanstiegsphase.

Das Bewertungsprodukt ist bevorzugt durch den folgenden Dreiecksoperator $\Delta_{Anstiegsphase}$ gebildet:

$$\Delta_{Anstiegsphase} = 0{,}5\ V \cdot ((I_{ab} + I_{ad}) \cdot t_{ab} - I_{ab} \cdot t_{ad})$$

Dabei sind $I_{ab} = I_b - I_a$ und $I_{ad} = I_d - I_a$.

Die Fehlfunktion des Aktuators wird bevorzugt dann erkannt, wenn der Dreiecksoperator $\Delta_{Anstiegsphase}$ mindestens so groß wie die für den Dreiecksoperator $\Delta_{An-stiegsphase}$ vorab definierte Bewertungsproduktgrenze ist.

Wenn der Dreiecksoperator $\Delta_{Anstiegsphase}$ groß ist, deutet dies darauf hin, dass der Strom $i(t)$ sehr schnell steigt, sodass weniger elektrische Energie in andere Energieformen gewandelt wird. Wenn der Dreiecksoperator $\Delta_{Anstiegsphase}$ kleiner ist, deutet dies darauf hin, dass für die Bewegung des Magnetkernes mehr elektrische Energie in kinetische Energie gewandelt wird. Eine Verkleinerung des Dreiecksoperators $\Delta_{Anstiegs-phase}$ deutet auch auf sich verändernde magnetische Eigenschaften hin, wie beispielsweise eine Verkleinerung eines Luftspaltes, wodurch mehr elektrische Energie gewandelt wird.

Bevorzugt wird der Stromdifferenzwert $I_{ab}$ als ein weiteres Kriterium zum Erkennen einer Fehlfunktion des Aktuators verwendet.

Bevorzugt wird ein Maß der Steigung des Stromes $i(t)$ nach dem Erreichen von $I_{ab}$ als ein weiteres Kriterium zum Erkennen einer Fehlfunktion des Aktuators verwendet.

Bevorzugt wird eine Dauer vom Erreichen des Stromanstiegsphasenanfangswertes bis zum Erreichen des Stromanstiegsphasenendwertes als ein weiteres Kriterium zum Erkennen einer Fehlfunktion des Aktuators verwendet.

Bevorzugt wird ein Schwerpunkt der das Bewertungsprodukt darstellenden Fläche als ein weiteres Kriterium zum Erkennen einer Fehlfunktion des Aktuators verwendet.

Bevorzugt wird ein Mittelpunkt der das Bewertungsprodukt darstellenden Fläche als ein weiteres Kriterium zum Erkennen einer Fehlfunktion des Aktuators verwendet.

Bevorzugt wird der Abweichungszeitpunkt als ein weiteres Kriterium zum Erkennen einer Fehlfunktion des Aktuators verwendet. Es erfolgt ein Erkennen einer Fehlfunktion des elektromagnetischen Aktuators, wenn der ermittelte Abweichungszeitpunkt früher als ein vorab definierter Normabweichungszeitpunkt liegt. Das Definieren des Normabweichungszeitpunktes erfolgt bevorzugt dadurch, dass der Abweichungszeitpunkt für mehrere korrekt funktionierende elektromagnetische Aktuatoren gleicher Bauart wie der zu überwachende elektromagnetische Aktuator ermittelt wird.

Bevorzugt wird der früheste der ermittelten Abweichungszeitpunkte um ein Toleranzmaß verringert und als der Normabweichungszeitpunkt verwendet.

Bei einer ersten Gruppe bevorzugter Ausführungsformen des erfindungsgemäßen Verfahrens liegt ein weiterer Bewertungsabschnitt innerhalb der Spitzenstromphase.

Bei der ersten Gruppe bevorzugter Ausführungsformen des erfindungsgemäßen Verfahrens ist der Abschnittsanfangsstromwert bevorzugt durch den Maximalstromwert gebildet.

Bei der ersten Gruppe bevorzugter Ausführungsformen des erfindungsgemäßen Verfahrens ist der Abschnittsendstromwert bevorzugt größer als der Spitzenstromphasenzwischenwert und wird zeitlich vor dem Spitzenstromphasenzwischenwert erreicht.

Bei der ersten Gruppe bevorzugter Ausführungsformen des erfindungsgemäßen Verfahrens ist das Bewertungsprodukt bevorzugt durch den folgenden Dreiecksoperator $\Delta_{Spitzenstromphase}$ gebildet:

$$\Delta_{Spitzenstromphase} = 0{,}5 \, V \cdot (I_{ab} \cdot t_{ad} + I_{bd} \cdot t_{ab})$$

Dabei sind $Ia_b = I_a - I_b$ und $I_{bd} = I_d - I_b$.

Die Fehlfunktion des Aktuators wird bevorzugt dann erkannt, wenn der Dreiecksoperator $\Delta_{Spitzenstromphase}$ höchstens so groß wie die für den Dreiecksoperator $\Delta_{Spitzenstromphase}$ vorab definierte Bewertungsproduktgrenze ist.

Wenn der Dreiecksoperator $\Delta_{Spitzenstromphase}$ klein ist, deutet dies auf ein rasches Entladen durch den Strom i(t) und auf eine geringe Energiewandlung zwischen kinetischer Energie und magnetischer Energie hin. Wenn der Dreiecksoperator $\Delta_{Spitzenstromphase}$ größer ist, deutet dies auf eine langsame Bewegung des Magnetkernes und auf eine geringe kinetische Energie hin. Eine Vergrößerung des Dreiecksoperators $\Delta_{Spitzenstrom-phase}$ deutet auch auf sich verändernde magnetische Eigenschaften hin, wie beispielsweise eine Verkleinerung eines Luftspaltes, wodurch weniger magnetische Energie vorhanden ist.

Bei der ersten Gruppe bevorzugter Ausführungsformen des erfindungsgemäßen Verfahrens wird bevorzugt der Stromdifferenzwert $I_{ab}$ als ein weiteres Kriterium zum Erkennen einer Fehlfunktion des Aktuators verwendet.

Bei der ersten Gruppe bevorzugter Ausführungsformen des erfindungsgemäßen Verfahrens wird bevorzugt ein Stromdifferenzwert $I_{min,}$ welcher durch die Differenz zwischen dem Spitzenstromphasenanfangswert und dem Spitzenstromphasenzwischenwert gebildet ist, als ein weiteres Kriterium zum Erkennen einer Fehlfunktion des Aktuators verwendet.

Bei der ersten Gruppe bevorzugter Ausführungsformen des erfindungsgemäßen Verfahrens wird bevorzugt eine Dauer $t_{min}$ vom Erreichen der Spitzenstromphasenanfangswertes bis zum Erreichen des Spitzenstromphasenzwischenwertes als ein weiteres Kriterium zum Erkennen einer Fehlfunktion des Aktuators verwendet.

Bei der ersten Gruppe bevorzugter Ausführungsformen des erfindungsgemäßen Verfahrens wird bevorzugt ein Operator $A_{Spitzenstromphase}$ als ein weiteres Kriterium zum Erkennen einer Fehlfunktion des Aktuators verwendet. Der Operator $A_{Spitzenstromphase}$ ist wie folgt definiert:

$$A_{Spitzenstromphase} = 0{,}5 \, V \cdot [I_{ab} \cdot t_{ab} - (I_{ab} \cdot t_{ad} + I_{bd} \cdot t_{ab})]$$

Bei der ersten Gruppe bevorzugter Ausführungsformen des erfindungsgemäßen Verfahrens wird bevorzugt ein Verhältnis des Dreieckoperators $\Delta_{Spitzenstromphase}$ zum Operator $A_{Spitzenstromphase}$ als ein weiteres Kriterium zum Erkennen einer Fehlfunktion des Aktuators verwendet.

Bei der ersten Gruppe bevorzugter Ausführungsformen des erfindungsgemäßen Verfahrens wird bevorzugt ein Schwerpunkt der das Bewertungsprodukt darstellenden Fläche als ein weiteres Kriterium zum Erkennen einer Fehlfunktion des Aktuators verwendet.

Bei der ersten Gruppe bevorzugter Ausführungsformen des erfindungsgemäßen Verfahrens wird bevorzugt ein Mittelpunkt der das Bewertungsprodukt darstellenden Fläche als ein weiteres Kriterium zum Erkennen einer Fehlfunktion des Aktuators verwendet.

Bei der ersten Gruppe bevorzugter Ausführungsformen des erfindungsgemäßen Verfahrens wird bevorzugt ein Verhältnis des Stromdifferenzwertes $I_{ab}$ zur Dauer $t_{ab}$ als ein weiteres Kriterium zum Erkennen einer Fehlfunktion des Aktuators verwendet.

Beider ersten Gruppe bevorzugter Ausführungsformen des erfindungsgemäßen Verfahrens wird bevorzugt eine Länge des Funktionsgraphen vom Spitzenstromphasenzwischenwert bis zum Spitzenstromphasenendwert als ein weiteres Kriterium zum Erkennen einer Fehlfunktion des Aktuators verwendet.

Bei einer zweiten Gruppe bevorzugter Ausführungsformen des erfindungsgemäßen Verfahrens liegt ein weiterer Bewertungsabschnitt innerhalb der Auslaufphase.

Bei der zweiten Gruppe bevorzugter Ausführungsformen des erfindungsgemäßen Verfahrens wird der Auslaufphasenanfangswert als der Abschnittsanfangsstromwert verwendet.

Bei der zweiten Gruppe bevorzugter Ausführungsformen des erfindungsgemäßen Verfahrens ist der Abschnittsendstromwert kleiner als der Auslaufphasenzwischenwert und wird zeitlich vor dem Auslaufphasenzwischenwert erreicht.

Bei der zweiten Gruppe bevorzugter Ausführungsformen des erfindungsgemäßen Verfahrens ist das Bewertungsprodukt bevorzugt durch den folgenden Dreiecksoperator $\Delta_{Auslaufphase}$ gebildet:

$$\Delta_{Auslaufphase} = 0,5 \, V \cdot ((I_{ab} - I_{ad}) \cdot t_{ab} + I_{ab} \cdot t_{ad})$$

Dabei sind $I_{ab} = I_b - I_a$ und $I_{ad} = I_d - I_a$.

Beider zweiten Gruppe bevorzugter Ausführungsformen des erfindungsgemäßen Verfahrens wird die Fehlfunktion des Aktuators bevorzugt dann erkannt, wenn der Dreiecksoperator $\Delta_{Auslaufphase}$ höchstens so groß wie die für den Dreiecksoperator $\Delta_{Auslauf\text{-} phase}$ vorab definierte Bewertungsproduktgrenze ist.

Wenn der Dreiecksoperator $\Delta_{Auslaufphase}$ klein ist, deutet dies auf kleine Stromwerte hin. Auch deutet dies auf einen schnellen Anstieg des Stromes i(t) hin und dass weniger elektrische Energie in andere Energieformen gewandelt wird. Auch deutet dies auf eine geringe Bewegung des Magnetkernes und auf wenig vorhandene kinetische Energie hin. Eine Vergrößerung des Dreiecksoperators $\Delta_{Auslaufphase}$ deutet auf eine vermehrte Wandlung elektrischer Energie in magnetische Energie hin, was beispielsweise durch eine Vergrößerung eines Luftspaltes bedingt ist.

Bei der zweiten Gruppe bevorzugter Ausführungsformen des erfindungsgemäßen Verfahrens wird bevorzugt der Stromdifferenzwert $I_{ab}$ als ein weiteres Kriterium zum Erkennen einer Fehlfunktion des Aktuators verwendet.

Bei der zweiten Gruppe bevorzugter Ausführungsformen des erfindungsgemäßen Verfahrens wird bevorzugt ein Verhältnis des Stromdifferenzwertes $I_{ab}$ zur Dauer $t_{ab}$ als ein weiteres Kriterium zum Erkennen einer Fehlfunktion des Aktuators verwendet.

Bei der zweiten Gruppe bevorzugter Ausführungsformen des erfindungsgemäßen Verfahrens wird bevorzugt eine Länge des Funktionsgraphen vom Auslaufphasenanfangswert bis zum Auslaufphasenzwischenwert als ein weiteres Kriterium zum Erkennen einer Fehlfunktion des Aktuators verwendet.

Bei der zweiten Gruppe bevorzugter Ausführungsformen des erfindungsgemäßen Verfahrens wird bevorzugt ein Dreiecksoperator $\Delta_{AuslaufphaseA}$ als ein weiteres Kriterium zum Erkennen einer Fehlfunktion des Aktuators verwendet. Der Operator Dreiecksoperator $\Delta_{AuslaufphaseA}$ ist wie folgt definiert:

$$\Delta_{AuslaufphaseA} = 0,5 \, V \cdot ((I_{ab} + I_{ad}) \cdot t_{ab} - I_{ab} \cdot t_{ad})$$

Bei der zweiten Gruppe bevorzugter Ausführungsformen des erfindungsgemäßen Verfahrens werden bevorzugt der Auslaufphasenzwischenwert und die Zeitdauer bis zu seinem Erreichen als weitere Kriterien zum Erkennen einer Fehlfunktion des Aktuators verwendet.

Bei der zweiten Gruppe bevorzugter Ausführungsformen des erfindungsgemäßen Verfahrens wird bevorzugt ein weiterer der Bewertungsabschnitte verwendet, der im späteren Teil der Auslaufphase liegt, d. h. nach dem Erreichen des Auslaufphasenzwischenwertes Der Auslaufphasenzwischenwert wird bevorzugt als der Abschnittsanfangsstromwert $I_a$ verwendet. Der Abschnittsendstromwert $I_b$ ist bevorzugt kleiner als der Auslaufphasenzwischenwert ist und wird zeitlich vor dem Auslaufphasenendwert erreicht.

Bei der zweiten Gruppe bevorzugter Ausführungsformen des erfindungsgemäßen Verfahrens wird bevorzugt für den späteren Teil der Auslaufphase ein Dreiecksoperator $\Delta_{AuslaufphaseB}$ als ein weiteres Kriterium zum Erkennen einer Fehlfunktion des Aktuators verwendet. Der Dreiecksoperator $\Delta_{AuslaufphaseB}$ ist wie folgt definiert:

$$\Delta_{AuslaufphaseB} = 0,5 \, V \cdot ((I_{ab} + I_{ad}) \cdot t_{ab} - I_{ab} \cdot t_{ad})$$

Dabei sind $I_{ab} = I_a - I_b$ und $I_{ad} = I_a - I_d$.

Bei der zweiten Gruppe bevorzugter Ausführungsformen des erfindungsgemäßen Verfahrens wird bevorzugt für den späteren Teil der Auslaufphase ein Dreiecksoperator $\Delta_{AuslaufphaseC}$ als ein weiteres Kriterium zum Erkennen einer Fehlfunktion des Aktuators verwendet. Der Dreiecksoperator $\Delta_{AuslaufphaseC}$ ist wie folgt definiert:

$$\Delta_{AuslaufphaseC} = 0,5 \, V \cdot ((I_{ab} - I_{ad}) \cdot t_{ab} + I_{ab} \cdot t_{ad})$$

Dabei sind $I_{ab} = I_a - I_b$ und $I_{ad} = I_a - I_d$.

Bei der zweiten Gruppe bevorzugter Ausführungsformen des erfindungsgemäßen Verfahrens wird bevorzugt eine Summe der Dreiecksoperatoren $\Delta_{Auslaufphase}$, $\Delta_{AuslaufphaseA}$, $\Delta_{AuslaufphaseB}$ und $\Delta_{AuslaufphaseC}$ als ein weiteres Kriterium zum Erkennen einer Fehlfunktion des Aktuators verwendet.

Bei der zweiten Gruppe bevorzugter Ausführungsformen des erfindungsgemäßen Verfahrens wird bevorzugt ein Schwerpunkt der das Bewertungsprodukt darstellenden Fläche als ein weiteres Kriterium zum Erkennen einer Fehlfunktion des Aktuators verwendet.

Bei der zweiten Gruppe bevorzugter Ausführungsformen des erfindungsgemäßen Verfahrens wird bevorzugt ein Mittelpunkt der das Bewertungsprodukt darstellenden Fläche als ein weiteres Kriterium zum Erkennen einer Fehlfunktion des Aktuators verwendet. Bei dem Mittelpunkt handelt es sich um einen zeitlichen Mittelpunkt und ggf. um einen mittleren Wert des gemessenen Stromes im Bewertungsabschnitt.

Bei der zweiten Gruppe bevorzugter Ausführungsformen des erfindungsgemäßen Verfahrens wird bevorzugt die Zwischenabschnittszeitdauer als ein weiteres Kriterium zum Erkennen einer Fehlfunktion des Aktuators verwendet.

Bei der zweiten Gruppe bevorzugter Ausführungsformen des erfindungsgemäßen Verfahrens wird bevorzugt mindestens ein Verhältnis zwischen den Dreiecksoperatoren als ein weiteres Kriterium zum Erkennen einer Fehlfunktion des Aktuators verwendet. Es wird bevorzugt mindestens eines der folgende Verhältnisse gebildet: $\Delta_{Auslaufpha-se}$ / $\Delta_{AuslaufphaseA}$, $\Delta_{Auslaufphase}$ / $\Delta_{AuslaufphaseB}$, $\Delta_{Auslaufphase}$ / $\Delta_{AuslaufphaseC}$, $\Delta_{Auslaufphase-A}$ / $\Delta_{AuslaufphaseB}$ und $\Delta_{AuslaufphaseC}$ / $\Delta_{AuslaufphaseB}$.

Die für die zwei Gruppen bevorzugter Ausführungsformen genannten bevorzugt anzuwendenden Kriterien zum Erkennen einer Fehlfunktion des Aktuators werden bevorzugt jeweils auch in Kombination angewendet. Bevorzugt werden die für die zwei Gruppen bevorzugter Ausführungsformen genannten Kriterien zum Erkennen einer Fehlfunktion des Aktuators auch gruppenübergreifend in Kombination angewendet, d. h., dass mehrere der für die zwei Gruppen bevorzugter Ausführungsformen genannten Kriterien zum Erkennen einer Fehlfunktion des Aktuators in Kombination gemeinsam angewendet werden.

Die erfindungsgemäße Steuerungseinheit dient zur Steuerung und Überwachung eines elektromagnetischen Aktuators und ist zur Ausführung des erfindungsgemäßen Verfahrens konfiguriert. Die erfindungsgemäße Steuerungseinheit ist bevorzugt zur Ausführung bevorzugter Ausführungsformen des erfindungsgemäßen Verfahrens konfiguriert.

Weitere Einzelheiten, Vorteile und Weiterbildungen der Erfindung ergeben sich aus der nachfolgenden Beschreibung bevorzugter Ausführungsformen der Erfindung, unter Bezugnahme auf die Zeichnung. Es zeigen:

Fig. 1 ein gemäß einer bevorzugten Ausführungsform eines erfindungsgemäßen Verfahrens zu überwachendes Schaltventil in einer Prinzipdarstellung;

Fig. 2 einen zeitlichen Verlauf eines Stromes zur Bestromung des in Fig.1 gezeigten Schaltventiles;

Fig. 3 einen zeitlichen Verlauf einer Bewegung eines in Fig.1 gezeigten Magnetkernes und eines in Fig.1 gezeigten Ventilkörpers bei einer Bestromung des Schaltventiles;

Fig. 4 einen Ausschnitt des in Fig. 2 gezeigten Verlaufes des Stromes im Detail mit einem nach einer bevorzugten Ausführungsform des erfindungsgemäßen Verfahrens zu bestimmenden Abweichungszeitpunkt;

Fig. 5 eine Stromanstiegsphase des in Fig. 4 gezeigten Verlaufes des Stromes mit einem nach einer bevorzugten Ausführungsform des erfindungsgemäßen Verfahrens zu bestimmenden Flächeninhalt;

Fig. 6 eine Spitzenstromphase des in Fig. 2 gezeigten Verlaufes des Stromes mit einem nach einer bevorzugten Ausführungsform des erfindungsgemäßen Verfahrens zu bestimmenden Flächeninhalt;

Fig. 7 die in Fig. 6 gezeigte Spitzenstromphase mit einem nach einer weiteren bevorzugten Ausführungsform des erfindungsgemäßen Verfahrens zu bestimmenden Flächeninhalt;

Fig. 8 eine Auslaufphase des in Fig. 2 gezeigten Verlaufes des Stromes mit einem nach einer bevorzugten Ausführungsform des erfindungsgemäßen Verfahrens zu bestimmenden Flächeninhalt; und

Fig. 9 die in Fig. 8 gezeigte Auslaufphase mit weiteren nach weiteren bevorzugten Ausführungsformen des erfindungsgemäßen Verfahrens zu bestimmenden Flächeninhalten.

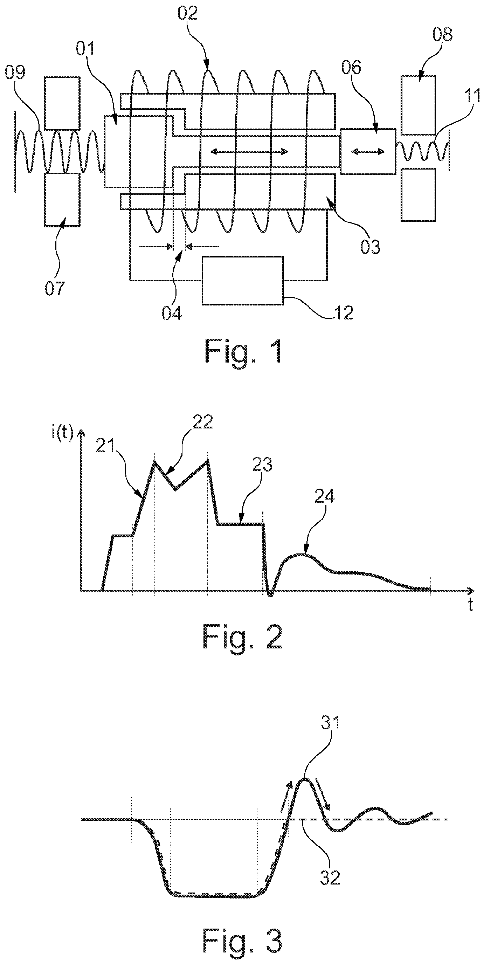

Fig. 1 zeigt ein gemäß einer bevorzugten Ausführungsform eines erfindungsgemäßen Verfahrens zu überwachendes Schaltventil in einer Prinzipdarstellung. Es stellt einen elektromagnetischen Aktuator dar und umfasst einen beweglichen Magnetkern 01, der in einer elektrischen Spule 02 verschiebbar ist. Die Spule 02 sitzt auf einem festen Magnetkern 03, in welchem der bewegliche Magnetkern 01 verschiebbar ist. Zwischen dem beweglichen Magnetkern 01 und dem festen Magnetkern 03 ist ein Luftspalt 04 ausgebildet.

Am beweglichen Magnetkern 01 ist ein Ventilkörper 06 befestigt, welcher einen Teil eines nicht näher dargestellten Ventiles bildet. Die Verschiebebewegung des beweglichen Magnetkernes 01 mit dem Ventilkörper 06 wird durch einen ersten Anschlag 07 und durch einen zweiten Anschlag 08 begrenzt. Die Verschiebebewegung des beweglichen Magnetkernes 01 mit dem Ventilkörper 06 wird durch eine erste Feder 09 und durch eine zweite Feder 11 gefedert.

An die elektrische Spule 02 ist eine Steuereinheit 12 elektrisch angeschlossen, mit welcher die Spule 02 des Schaltventiles bestrombar ist. Hierfür wird die Spule 02 durch die Steuereinheit 12 mit einer Betriebsspannung V beaufschlagt, woraufhin ein von der Zeit abhängiger Strom i(t) durch die Spule 02 fließt. Die Steuereinheit 12 ist zur Ausführung des erfindungsgemäßen Verfahrens konfiguriert, welches nachfolgend erläutert wird.

Fig. 2 zeigt einen zeitlichen Verlauf des mit Bezug auf die Fig.1 beschriebenen Stromes i(t). Der Strom i(t) steigt nach der Beaufschlagung durch die Betriebsspannung V während einer Stromanstiegsphase 21 an und durchläuft eine Spitzenstromphase 22, woraufhin er bis zum Ende der Beaufschlagung durch die Betriebsspannung V in einer Haltestromphase 23 verbleibt. Nach der Beaufschlagung durch die Betriebsspannung V schließt sich eine Auslaufphase 24 an.

Fig. 3 zeigt einen zeitlichen Verlauf einer Bewegung des in Fig.1 gezeigten Magnetkernes 01 und des in Fig.1 gezeigten Ventilkörpers 06 bei einer Bestromung des Schaltventiles. Der zeitliche Verlauf der Bewegung des in Fig.1 gezeigten Magnetkernes 01 ist durch eine durchgezogene Linie 31 im Diagramm dargestellt. Der zeitliche Verlauf der Bewegung des in Fig.1 gezeigten Ventilkörpers 06 ist durch eine gestrichelte Linie 32 im Diagramm dargestellt.

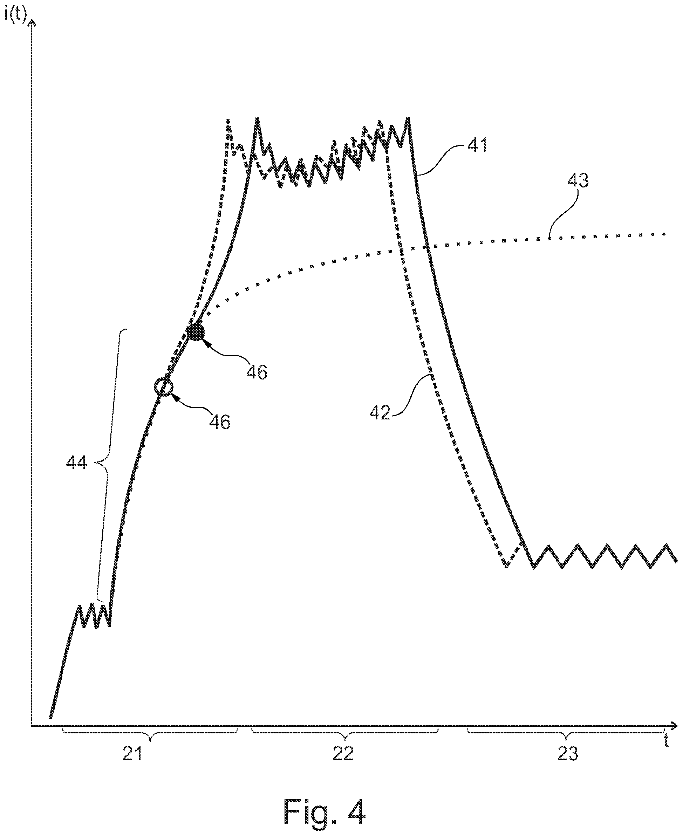

Fig. 4 zeigt einen Ausschnitt des in Fig. 2 gezeigten Verlaufes des Stromes i(t) im Detail. Dieser Verlauf ist mit einer durchgezogenen Linie 41 für den Fall dargestellt, dass das Schaltventil fehlerfrei funktioniert. Dieser Verlauf ist mit einer gestrichelten Linie 42 für den Fall dargestellt, dass das Schaltventil blockiert ist. Eine gepunktete Linie 43 veranschaulicht den Fall, wenn das Schaltventil und dessen Bestromung so dimensioniert wären, dass es nicht zur magnetischen Sättigung im Schaltventil kommt, und zudem das Schaltventil blockiert ist. Allerdings sind Schaltventile üblicherweise so dimensioniert, dass sie nahe oder in der elektromagnetischen Sättigung arbeiten. Der Strom i(t) steigt zunächst exponentiell, jedoch kommt es wegen der elektromagnetische Sättigung zu einem steileren Anstieg. Bei einem fehlerfrei funktionierenden Schaltventil wird ein Teil der elektrischen Energie in kinetische Energie gewandelt. Bei einem blockierten Schaltventil führt die elektrische Energie in einem höheren Maße zur elektromagnetischen Sättigung, sodass der exponentielle Verlauf des Stromes i(t) früher verlassen wird.

Während einer Leerlaufphase 44 befindet sich der bewegliche Magnetkern 01 (gezeigt in Fig. 1) noch im Leerlauf. In der Leerlaufphase 44 verläuft der Strom i(t) logarithmisch. Nach der Leerlaufphase 44 kommt es zur magnetischen Sättigung des Schaltventiles, sodass der Strom i(t) stärker als gemäß dem logarithmischen Verlauf steigt. Das Einsetzen dieser stärkeren Steigung des Stromes i(t) setzt an einem Abweichungspunkt 46 ein. Ist das Schaltventil blockiert, so kommt es wie oben beschrieben früher zur magnetischen Sättigung des Schaltventiles, sodass der Abweichungspunkt 46 zeitlich früher liegt. Der Abweichungszeitpunkt 46 wird während der Bestromung des Schaltventiles ermittelt. Liegt er zeitlich vor einem vorab definierten Normabweichungszeitpunkt, so wird gemäß bevorzugter Ausführungsformen des erfindungsgemäßen Verfahrens eine Blockierung des Schaltventiles erkannt und es wird eine Fehlermeldung ausgegeben.

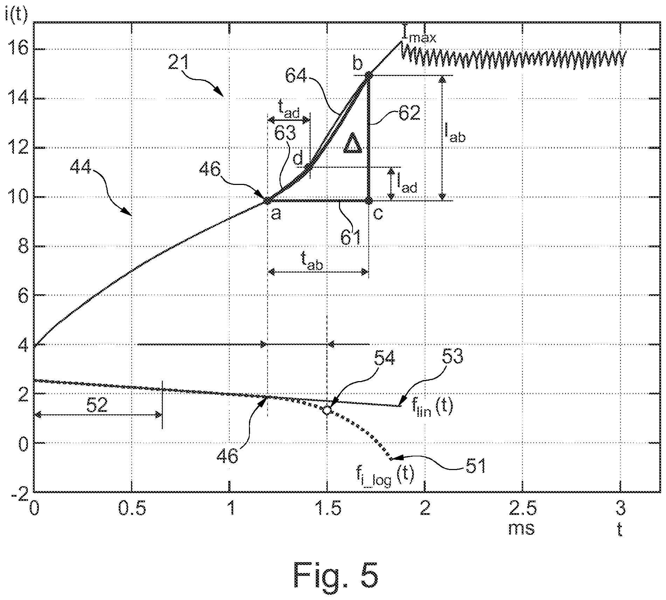

Fig. 5 zeigt insbesondere die Stromanstiegsphase 21 des in Fig. 4 gezeigten Verlaufes des Stromes i(t), wobei die Ermittlung des Abweichungszeitpunktes 46 veranschaulicht ist. Zunächst wird eine Logarithmusfunktion $f_{i\_log}(t)$ des zeitlichen Verlaufes des gemessenen Stromes i(t) ermittelt, die durch eine gestrichelte Linie 51 dargestellt ist. Für die Bildung der Logarithmusfunktion $f_{i\_log}(t)$ wird neben dem Strom i(t) auch ein Maximalstromwert $I_{max}$ berücksichtigt. Eine positive Konstante c als Summand im Argument der Logarithmusfunktion $f_{i\text{-}log}(t)$ garantiert, dass das Argument immer positiv ist. Die Logarithmusfunktion $f_{i\_log}(t)$ wird wie folgt bestimmt:

$$f_{i\_log}(t) = \log[\, i(t) - I_{max} + c\, ]$$

Die Logarithmusfunktion $f_{i\_log}(t)$ verläuft zunächst linear. In einem frühen zeitlichen Teilabschnitt 52 der Leerlaufphase erfolgt eine lineare Approximation der Logarithmusfunktion $f_{i\_log}(t)$, in deren Ergebnis eine lineare Funktion $f_{lin}(t)$ erhalten wird, die durch eine dünne durchgezogene Linie 53 dargestellt ist. Zu einem Differenzmaßzeitpunkt 54 weichen die Logarithmusfunktion $f_{i\_log}(t)$ und die lineare Funktion $f_{lin}(t)$ um ein vorbestimmtes Differenzmaß voneinander ab. Von diesem Differenzmaßzeitpunkt 54 wird eine Kalibrierungszeitdauer abgezogen, wodurch der Abweichungszeitpunkt 46 erhalten wird.

Während der Stromanstiegsphase 21 des Verlaufes des Stromes i(t) wird nach einer bevorzugten Ausführungsform des erfindungsgemäßen Verfahrens weiterhin ein Flächeninhalt bestimmt, der einen Dreiecksoperator $\Delta$ repräsentiert. Der Dreiecksoperator $\Delta$ wird in einem Bewertungsabschnitt bestimmt, welcher in einem mit dem Abweichungspunkt 46 zusammenfallenden Punkt a beginnt und bis in einem Punkt b nahezu auf den Spitzenstrom $I_{max}$ steigt. Der Bewertungsabschnitt dauert eine Zeitdauer $t_{ab}$. Der Strom i(t) steigt während des Bewertungsabschnittes um einen Stromdifferenzwert $I_{ab}$. Zwischen dem Punkt a und dem Punkt b wird ein Punkt d auf dem Funktionsgraphen des Stromes i(t) ausgewählt. Der zeitliche Abschnitt vom Punkt a bis zum Punkt d stellt einen Bewertungsteilabschnitt dar, welcher eine Zeitdauer $t_{ad}$ dauert. Im Punkt d ist der Strom i(t) um einen Stromdifferenzwert $I_{ad}$ größer als im Punkt a. Durch den Punkt a verläuft eine erste Gerade 61, die parallel zur Achse der Zeit t ausgerichtet ist. Durch den Punkt b verläuft eine zweite Gerade 62, die parallel zur Achse des Stromes i(t) ausgerichtet ist. Die erste Gerade 61 und die zweite Gerade 62 schneiden sich in einem Punkt c. Eine dritte Gerade 63 verläuft durch die Punkte a und d. Eine vierte Gerade 64 verläuft durch die Punkte d und b. Die erste Gerade 61, die zweite Gerade 62, die dritte Gerade 63 und die vierte Gerade 64 spannen ein Viereck auf, welches auch als ein rechtwinkliges Dreieck mit einer ungeraden Hypotenuse aufgefasst werden kann, die aus der dritten Gerade 63 und der vierten Gerade 64 gebildet ist. Die aus der dritten Gerade 63 und der vierten Gerade 64 gebildete Hypotenuse stellt eine Annäherung an den Funktionsverlauf des Stromes i(t) im Bewertungsabschnitt dar. Der Flächeninhalt des rechtwinkligen Dreieckes mit der ungeraden Hypotenuse bildet den Dreiecksoperator $\Delta$. Eine Blockierung des Schaltventiles wird erkannt, wenn der für die Stromanstiegsphase gebildete Dreiecksoperator $\Delta$ mindestens so groß wie eine vorab definierte Bewertungsproduktgrenze ist.

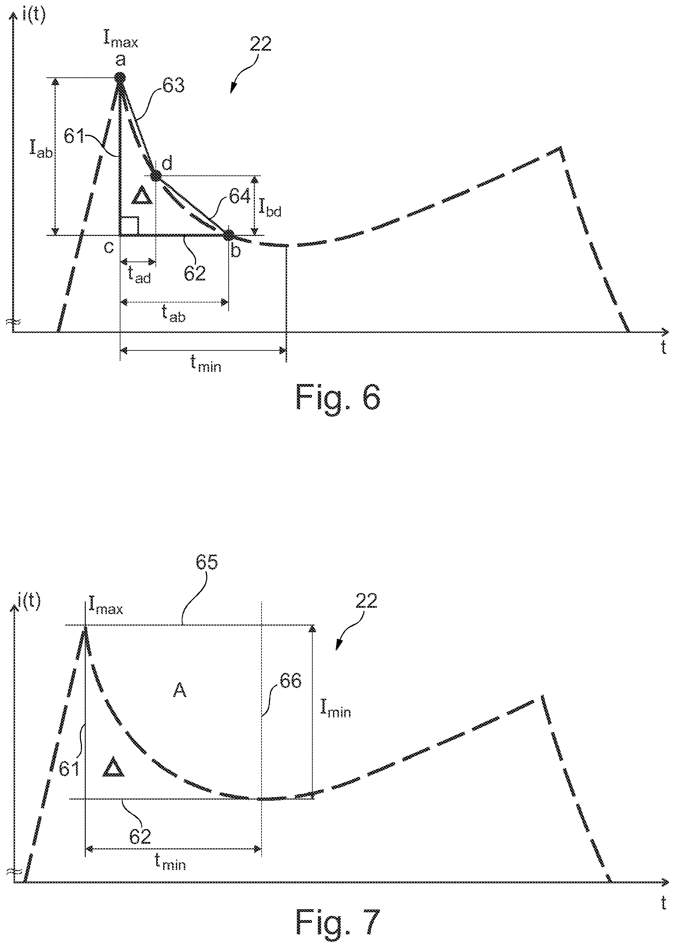

Fig. 6 zeigt die in Fig. 2 gezeigte Spitzenstromphase 22 des Verlaufes des Stromes i(t) mit einem nach einer bevorzugten Ausführungsform des erfindungsgemäßen Verfahrens zu bestimmenden Flächeninhalt, der einen weiteren Dreiecksoperator $\Delta$ repräsentiert. Der Dreiecksoperator $\Delta$ wird in einem weiteren Bewertungsabschnitt bestimmt, in welchem der Strom i(t) in einem Punkt a von einem Spitzenstromphasenanfangswert bis in einem Punkt b nahezu auf einen Spitzenstromphasenzwischenwert sinkt. Bei dem Spitzenstromphasenanfangswert handelt es sich um den Spitzenstrom $I_{max}$. Der Bewertungsabschnitt dauert wiederum eine Zeitdauer $t_{ab}$. Der Strom i(t) sinkt während des Bewertungsabschnittes um einen Stromdifferenzwert $I_{ab}$. Zwischen dem Punkt a und dem Punkt b wird wiederum ein Punkt d auf dem Funktionsgraphen des Stromes i(t) ausgewählt. Der zeitliche Abschnitt vom Punkt a zum Punkt d stellt einen Bewertungsteilabschnitt dar, welcher eine Zeitdauer $t_{ad}$ dauert. Im Punkt d ist der Strom i(t) um einen Stromdifferenzwert $I_{bd}$ größer als im Punkt b. Durch den Punkt a verläuft wiederum eine erste Gerade 61, die jedoch parallel zur Achse des Stromes i(t) ausgerichtet ist. Durch den Punkt b verläuft wiederum eine zweite Gerade 62, die jedoch parallel zur Achse der Zeit t ausgerichtet ist. Die erste Gerade 61 und die zweite Gerade 62 schneiden sich wiederum in einem Punkt c. Eine dritte Gerade 63 verläuft wiederum durch die Punkte a und d. Eine vierte Gerade 64 verläuft wiederum durch die Punkte d und b. Die erste Gerade 61, die zweite Gerade 62, die dritte Gerade 63 und die vierte Gerade 64 spannen ein Viereck auf, welches auch als ein rechtwinkliges Dreieck mit einer ungeraden Hypotenuse aufgefasst werden kann, die aus der dritten Gerade 63 und der vierten Gerade 64 gebildet ist. Die aus der dritten Gerade 63 und der vierten Gerade 64 gebildete Hypotenuse stellt eine Annäherung an den Funktionsverlauf des Stromes i(t) im Bewertungsabschnitt dar. Der Flächeninhalt des rechtwinkligen Dreieckes mit der ungeraden Hypotenuse bildet wiederum den Dreiecksoperator $\Delta$. Eine Blockierung des Schaltventiles wird erkannt, wenn der für die Spitzenstromphase gebildete Dreiecksoperator $\Delta$ höchstens so groß wie eine vorab definierte Bewertungsproduktgrenze ist.

Fig. 7 zeigt die in Fig. 6 gezeigte Spitzenstromphase 22 mit einem nach einer weiteren bevorzugten Ausführungsform des erfindungsgemäßen Verfahrens zu bestimmenden Flächeninhalt. Es wird ein abweichender Bewertungsabschnitt bestimmt, in welchem der Strom i(t) vom Spitzenstromphasenanfangswert bis vollständig auf den Spitzenstromphasenzwischenwert sinkt. Dieser Bewertungsabschnitt dauert eine Zeitdauer $t_{min}$. Während dieses Bewertungsabschnittes sinkt der Strom i(t) um einen Stromdifferenzwert $I_{min}$. Durch den Zeitpunkt des Spitzenstromphasenanfangswertes verläuft wiederum eine erste Gerade 61, die parallel zur Achse des Stromes i(t) ausgerichtet ist. Durch den Spitzenstromphasenzwischenwert verläuft wiederum eine zweite Gerade 62, die parallel zur Achse der Zeit t ausgerichtet ist. Gemäß einer alternativ bevorzugten Ausführungsform wird der Flächeninhalt einer Fläche bestimmt, welche von der ersten Gerade 61, der zweiten Gerade 62 und dem Funktionsgraphen des Stromes i(t) begrenzt wird. Dieser Flächeninhalt stellt einen alternativ bevorzugten Dreiecksoperator $\Delta$ dar. Durch den Spitzenstromphasenanfangswert verläuft eine fünfte Gerade 65, die parallel zur Achse der Zeit t ausgerichtet ist. Durch den Zeitpunkt des Spitzenstromphasenzwischenwertes verläuft eine sechste Gerade 66, die parallel zur Achse des Stromes i(t) ausgerichtet ist. Gemäß einer alternativ bevorzugten Ausführungsform wird der Flächeninhalt einer Fläche bestimmt, welche von der fünften Gerade 65, der sechsten Gerade 66 und dem Funktionsgraphen des Stromes i(t) begrenzt wird. Dieser Flächeninhalt stellt einen Operator A dar, der gemäß einer alternativ bevorzugten Ausführungsform als ein Kriterium zum Erkennen einer Fehlfunktion des Aktuators genutzt wird.

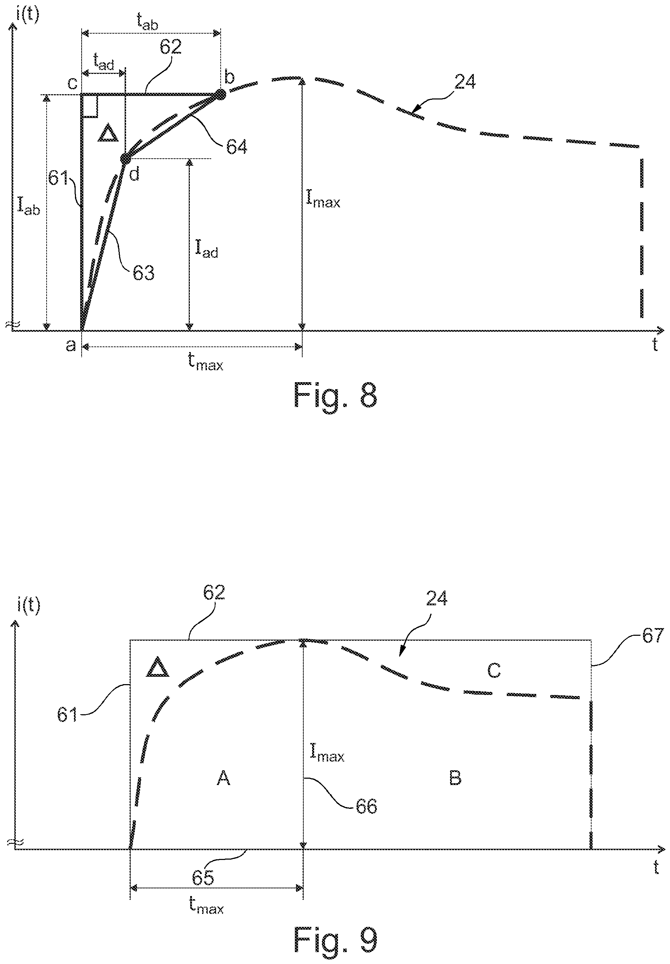

Fig. 8 zeigt die in Fig. 2 gezeigte Auslaufphase 24 des Verlaufes des Stromes i(t) mit einem nach einer bevorzugten Ausführungsform des erfindungsgemäßen Verfahrens zu bestimmenden Flächeninhalt, der einen weiteren Dreiecksoperator $\Delta$ repräsentiert. Der Dreiecksoperator $\Delta$ wird in einem weiteren Bewertungsabschnitt bestimmt, in welchem der Strom i(t) in einem Punkt a von einem Auslaufhasenanfangsstromwert bis in einem Punkt b nahezu auf einen maximalen Auslaufhasenzwischenstromwert steigt. Der Bewertungsabschnitt dauert wiederum eine Zeitdauer $t_{ab}$. Der Strom i(t) steigt während des Bewertungsabschnittes um einen Stromdifferenzwert $I_{ab}$. Zwischen dem Punkt a und dem Punkt b wird wiederum ein Punkt d auf dem Funktionsgraphen des Stromes i(t) ausgewählt. Der zeitliche Abschnitt vom Punkt a bis zum Punkt d stellt einen Bewertungsteilabschnitt dar, welcher eine Zeitdauer $t_{ad}$ dauert. Im Punkt d ist der Strom i(t) um einen Stromdifferenzwert $I_{ad}$ größer als im Punkt a. Durch den Punkt a verläuft wiederum eine erste Gerade 61, die parallel zur Achse des Stromes i(t) ausgerichtet ist. Durch den Punkt b verläuft wiederum eine zweite Gerade 62, die parallel zur Achse der Zeit t ausgerichtet ist. Die erste Gerade 61 und die zweite Gerade 62 schneiden sich wiederum in einem Punkt c. Eine dritte Gerade 63 verläuft wiederum durch die Punkte a und d. Eine vierte Gerade 64 verläuft wiederum durch die Punkte d und b. Die erste Gerade 61, die zweite Gerade 62, die dritte Gerade 63 und die vierte Gerade 64 spannen ein Viereck auf, welches auch als ein rechtwinkliges Dreieck mit einer ungeraden Hypotenuse aufgefasst werden kann, die aus der dritten Gerade 63 und der vierten Gerade 64 gebildet ist. Die aus der dritten Gerade 63 und der vierten Gerade 64 gebildete Hypotenuse stellt eine Annäherung an den Funktionsverlauf des Stromes i(t) im Bewertungsabschnitt dar. Der Flächeninhalt des rechtwinkligen Dreieckes mit der ungeraden Hypotenuse bildet wiederum den Dreiecksoperator $\Delta$. Eine Blockierung des Schaltventiles wird erkannt, wenn der für die Spitzenstromphase gebildete Dreiecksoperator $\Delta$ höchstens so groß wie eine vorab definierte Bewertungsproduktgrenze ist.

Fig. 9 zeigt die in Fig. 8 gezeigte Spitzenstromphase 24 mit weiteren nach weiteren bevorzugten Ausführungsformen des erfindungsgemäßen Verfahrens zu bestimmenden Flächeninhalten. Es wird ein abweichender Bewertungsabschnitt bestimmt, in welchem der Strom i(t) vom Auslaufphasenanfangsstromwert bis vollständig auf den maximalen Auslaufphasenzwischenstromwert steigt. Dieser Bewertungsabschnitt dauert eine Zeitdauer $t_{max}$. Während dieses Bewertungsabschnittes steigt der Strom i(t) um einen Stromdifferenzwert $I_{max}$. Durch den Auslaufphasenanfangsstromwert verläuft eine fünfte Gerade 65, die parallel zur Achse der Zeit t ausgerichtet ist. Durch den Zeitpunkt des maximalen Auslaufphasenzwischenstromwertes verläuft eine sechste Gerade 66, die parallel zur Achse des Stromes i(t) ausgerichtet ist. Gemäß einer alternativ bevorzugten Ausführungsform wird der Flächeninhalt einer Fläche A bestimmt, welche von der fünften Gerade 65, der sechsten Gerade 66 und dem Funktionsgraphen des Stromes i(t) begrenzt wird. Dieser Flächeninhalt stellt einen Dreiecksoperator $\Delta_A$ dar, der gemäß einer alternativ bevorzugten Ausführungsform als ein Kriterium zum Erkennen einer Fehlfunktion des Aktuators genutzt wird.

Alternativ oder ergänzend bevorzugt wird ein abweichender Bewertungsabschnitt bestimmt, in welchem der Strom i(t) vom maximalen Auslaufphasenzwischenstromwert bis auf einen Auslaufphasenendstromwert sinkt. Durch den Auslaufphasenendstromwert verläuft eine siebente Gerade 67, die parallel zur Achse des Stromes i(t) ausgerichtet ist. Gemäß einer alternativ bevorzugten Ausführungsform wird der Flächeninhalt einer Fläche B bestimmt, welche von der fünften Gerade 65, der sechsten Gerade 66, der siebenten Gerade 67 und dem Funktionsgraphen des Stromes i(t) begrenzt wird. Dieser Flächeninhalt stellt einen alternativ bevorzugten Dreiecksoperator $\Delta_B$ dar. Gemäß einer weiteren alternativ bevorzugten Ausführungsform wird der Flächeninhalt einer Fläche C bestimmt, welche von der zweiten Gerade 62, der siebenten Gerade 67 und dem Funktionsgraphen des Stromes i(t) begrenzt wird. Dieser Flächeninhalt stellt einen alternativ bevorzugten Dreiecksoperator $\Delta_C$ dar. Die verschiedenen Dreiecksoperatoren und weiteren Operatoren können erfindungsgemäß einzeln oder in Kombination als Kriterien zum Erkennen einer Fehlfunktion des Aktuators genutzt werden.

## Bezugszeichenliste

01    beweglicher Magnetkern
02    elektrische Spule
03    fester Magnetkern
04    Luftspalt
05    -
06    Ventilkörper
07    erster Anschlag
08    zweiter Anschlag
09    erste Feder
10    -
11    zweite Feder
12    Steuereinheit
20    -
21    Stromanstiegsphase
22    Spitzenstromphase
23    Haltestromphase
24    Auslaufphase
30    -
31    Bewegung des Magnetkernes (durchgezogene Linie)
32    Bewegung des Ventilkörpers (gestrichelte Linie)
40    -
41    Verlauf des Stromes i(t) (durchgezogene Linie)
42    Verlauf des Stromes i(t) bei blockiertem Schaltventil (gestrichelte Linie)
43    Verlauf des Stromes i(t) ohne magnetische Sättigung (gepunktete Linie)

44 Leerlaufphase
45 -
46 Abweichungszeitpunkt
50 -
51 Logarithmusfunktion $f_{i\_log}(t)$ (gestrichelte Linie)
52 früher zeitlicher Teilabschnitt der Leerlaufphase
53 lineare Funktion $f_{lin}(t)$ (dünne durchgezogene Linie)
54 Differenzmaßzeitpunkt
60 -
61 erste Gerade
62 zweite Gerade
63 dritte Gerade
64 vierte Gerade
65 fünfte Gerade
66 sechste Gerade
67 siebente Gerade

**Patentansprüche**

1. Verfahren zum Überwachen der Funktion eines elektromagnetischen Aktuators, wobei in dem elektromagnetischen Aktuator ein Magnetkern (01) durch Bestromung einer elektrischen Spule (02) verschiebbar ist; und wobei das Verfahren folgende Schritte umfasst:

   - Messen eines sich zeitlich verändernden, durch die elektrische Spule (02) fließenden Stromes;
   - Auswählen mindestens eines zeitlichen Bewertungsabschnittes des Verlaufes des gemessenen Stromes, in welchem sich der Strom von einem Abschnittsanfangsstromwert auf einen Abschnittsendstromwert ändert, wobei der zeitliche Bewertungsabschnitt eine Abschnittszeitdauer dauert;
   - Bilden eines Bewertungsproduktes aus Faktoren, welche zumindest einerseits den Abschnittsanfangsstromwert und den Abschnittsendstromwert sowie andererseits die Abschnittszeitdauer umfassen;
   - Erkennen einer Fehlfunktion des Aktuators durch Vergleichen des Bewertungsproduktes mit einer Bewertungsproduktgrenze;

   **dadurch gekennzeichnet, dass** der durch die elektrische Spule (02) fließende Strom während einer Stromanstiegsphase (21) steigt, in deren Verlauf sich der Magnetkern (01) zunächst im Leerlauf befindet; wobei sich an die Stromanstiegsphase (21) eine Spitzenstromphase (22) anschließt, in welcher der Strom von einem Spitzenstromphasenanfangswert auf eine Spitzenstromphasenzwischenwert sinkt und vom Spitzenstromphasenzwischenwert auf einen Spitzenstromphasenendwert steigt; wobei sich an die Spitzenstromphase (22) eine Haltestromphase (23) anschließt, in welcher der Strom bis in einen Haltestromwertbereich sinkt und dort verbleibt; und wobei sich an die Haltestromphase (23) eine Auslaufphase (24) anschließt, in welcher der Strom von einem Auslaufphasenanfangsstromwert auf einen Auslaufphasenzwischenstromwert steigt und vom Auslaufphasenzwischenstromwert auf einen Auslaufphasenendstromwert sinkt; und dass ein Bewertungsabschnitt innerhalb der Stromanstiegsphase (21) liegt; wobei der Abschnittsendstromwert kleiner als ein Maximalstromwert ist und zeitlich vor dem Ende der Stromanstiegsphase (21) liegt; und wobei der Abschnittsanfangsstromwert zu einem Abweichungszeitpunkt gegeben ist, der durch folgende Teilschritte ermittelt wird:

   - Bilden einer Logarithmusfunktion des in der Stromanstiegsphase (21) gemessenen Stromes;
   - Approximieren der einen frühen zeitlichen Teilabschnitt des Leerlaufes repräsentierenden Logarithmusfunktion durch eine Linearfunktion;
   - laufendes Bestimmen einer Differenz zwischen der Logarithmusfunktion und der Linearfunktion über den frühen zeitlichen Teilabschnitt des Leerlaufes hinweg; und

   Ermitteln des Abweichungszeitpunktes ausgehend davon, wann die Differenz ein vorab definiertes Differenzmaß erreicht.

2. Verfahren nach Anspruch 1, **dadurch gekennzeichnet, dass** das Bewertungsprodukt einen Flächeninhalt einer Fläche an einem Funktionsgraphen des zeitlich veränderlichen Stromes repräsentiert, wobei die Fläche zumindest durch einen dem Abschnittsanfangsstromwert zugeordneten Punkt des Funktionsgraphen und durch einen dem Abschnittsendstromwert zugeordneten Punkt des Funktionsgraphen begrenzt wird.

3. Verfahren nach Anspruch 2, **dadurch gekennzeichnet, dass** die Fläche durch eine durch den dem Abschnittsanfangsstromwert zugeordneten Punkt des Funktionsgraphen laufende erste Gerade (61), die parallel zu einer Achse der Zeit oder parallel zu einer Achse des Stromes ist, begrenzt wird; und dass die Fläche durch eine durch den dem Abschnittsendstromwert zugeordneten Punkt des Funktionsgraphen laufende zweite Gerade (62), die parallel zu einer Achse der Zeit oder parallel zu einer Achse des Stromes ist, begrenzt wird.

4. Verfahren nach Anspruch 2 oder 3, **dadurch gekennzeichnet, dass** die Fläche weiterhin durch einen dem Bewertungsabschnitt zugeordneten Teil des Funktionsgraphen begrenzt wird.

5. Verfahren nach Anspruch 2 oder 3, **dadurch gekennzeichnet, dass** ein dem Bewertungsabschnitt zugeordneter Teil des Funktionsgraphen in einem ersten Bewertungsteilabschnitt durch eine dritte Gerade (63) approximiert wird; und dass der dem Bewertungsabschnitt zugeordnete Teil des Funktionsgraphen in einem zweiten Bewertungsteilabschnitt durch eine vierte Gerade (64) approximiert wird; wobei die Fläche durch ein Viereck gebildet ist, dessen Seiten durch die erste Gerade (61), durch die zweite Gerade (62), durch die dritte Gerade (63) und durch die vierte Gerade (64) gebildet sind.

6. Verfahren nach einem der Ansprüche 1 bis 5, **dadurch gekennzeichnet, dass** ein weiterer Bewertungsabschnitt innerhalb der Spitzenstromphase (22) liegt, wobei der Abschnittsendstromwert größer als der Spitzenstromphasenzwischenwert ist und zeitlich vor dem Spitzenstromphasenzwischenwert erreicht wird.

7. Verfahren nach einem der Ansprüche 1 bis 6, **dadurch gekennzeichnet, dass** ein weiterer Bewertungsabschnitt innerhalb der Auslaufphase (24) liegt, wobei der Auslaufphasenanfangswert als der Abschnittsanfangsstromwert verwendet wird, und wobei der Abschnittsendstromwert kleiner als der Auslaufphasenzwischenwert ist und zeitlich vor dem Auslaufphasenzwischenwert erreicht wird.

8. Steuerungseinheit (12) zur Steuerung und Überwachung eines elektromagnetischen Aktuators, die zur Ausführung eines Verfahrens nach einem der Ansprüche 1 bis 7 konfiguriert ist.

**Claims**

1. A method for monitoring the function of an electromagnetic actuator, wherein a magnetic core (01), which is arranged in the electromagnetic actuator, can be moved by supplying current to an electric coil (02); and wherein the method comprises the following steps:

   - Measuring a time-varying current flowing through the electric coil (02);
   - Selecting at least one temporal evaluation section of the path of the measured current in which the current changes from a section initial current value to a section end current value, the temporal evaluation section having a section duration;
   - Forming an evaluation product from factors comprising at least, on the one hand, the section initial current value and the section end current value and, on the other hand, the section duration;
   - Detecting a malfunction of the actuator by comparing the evaluation product with an evaluation product boundary;

   **characterised in that** the current flowing through the electric coil (02) during a current increase phase (21) increases, in the course of which the magnetic core (01) is initially in idle; wherein the current increase phase (21) is followed by a peak current phase (22) in which the current decreases from a peak current phase initial value to a peak current phase intermediate value and increases from the peak current phase intermediate value to a peak current phase end value; wherein the peak current phase (22) is followed by a holding current phase (23) in which the current drops and remains in a holding current value range; and wherein the holding current phase (23) is followed by a phase-out phase (24) in which the current increases from a phase-out phase initial current value to a phase-out phase intermediate value and drops from the phase-out phase intermediate value to a phase-out phase end current value;
   and that an evaluation section lies within the current increase phase (21);
   wherein the section end current value is less than a maximum current value and lies before the end of the current increase phase (21); and wherein the section initial current value is given at a deviation point determined by the following substeps:

- Forming a logarithmic function of the current measured in the current increase phase (21);
- Approximating the logarithmic function representing an early temporal segment of idle by a linear function;
- Continuously determining a difference between the logarithmic function and the linear function over the early segment of the idle time; and

Obtaining the deviation point based on when the difference reaches a predefined difference measure.

2. The method according to claim 1, **characterised in that** the evaluation product represents a surface area of a surface on a function graph of the time-varying current, wherein the surface is bounded at least by a point of the function graph associated with the section initial current value and by a point of the function graph associated with the section end current value.

3. The method according to claim 2, **characterised in that** the area is bounded by a first straight line (61) which runs through the point of the function graph associated with the section initial current value and is parallel to an axis of time or parallel to an axis of the current; and that the area is bounded by a second straight line (62) which runs through the point of the function graph value associated with the section end current value and is parallel to an axis of time or parallel to an axis of the current.

4. The method according to claim 2 or 3, **characterised in that** the area is further bounded by a part of the function graph associated with the evaluation section.

5. The method according to claim 2 or 3, **characterised in that** a part of the function graph associated with the evaluation section is approximated in a first evaluation section by a third straight line (63); and that the part of the function graph associated with the evaluation section in a second evaluation section is approximated by a fourth straight line (64); wherein the area is formed by a quadrilateral, the sides of which are formed by the first straight line (61), by the second straight line (62), by the third straight line (63), and by the fourth straight line (64).

6. The method according to any one of claims 1 to 5, **characterised in that** a further evaluation section lies within the peak current phase (22), wherein the section end current value is greater than the peak current phase intermediate value and is reached earlier than the peak current phase intermediate value.

7. The method according to any one of claims 1 to 6, **characterised in that** a further evaluation section lies within the phase-out phase (24), wherein the phase-out phase initial value is used as the section initial current value, and wherein the section end current value is less than the phase-out phase intermediate value and is reached earlier than the phase-out phase intermediate value.

8. A control unit (12) for controlling and monitoring an electromagnetic actuator, configured to carry out a method according to any one of claims 1 to 7.

**Revendications**

1. Procédé de surveillance du fonctionnement d'un actionneur électromagnétique, dans lequel, dans l'actionneur électromagnétique, un noyau magnétique (01) peut être déplacé par excitation d'une bobine électrique (02) ; et dans lequel le procédé comprend les étapes suivantes :

- mesure d'un courant circulant dans la bobine électrique (02) qui se modifie dans le temps ;
- sélection d'au moins un segment temporel d'évaluation de la courbe du courant mesuré dans lequel le courant se modifie d'une valeur de courant au début du segment à une valeur de courant à la fin du segment, le segment temporel d'évaluation présentant une certaine durée ;
- formation d'un produit d'évaluation à partir de facteurs comprenant, au moins d'une part, la valeur de courant au début du segment et la valeur de courant à la fin du segment et, d'autre part, la durée du segment ;
- détection d'un dysfonctionnement de l'actionneur par comparaison du produit d'évaluation avec une limite de produit d'évaluation ;

**caractérisé en ce que** le courant circulant dans la bobine électrique (02) augmente pendant une phase d'augmentation de courant (21), au cours de laquelle le noyau magnétique (01) est initialement inactif ; dans lequel la phase d'augmentation de courant (21) est suivie d'une phase de courant de crête (22) dans laquelle le courant décroît d'une valeur initiale de phase de courant de crête à une valeur intermédiaire de phase de courant de crête et augmente à partir de la valeur intermédiaire de phase de courant de crête jusqu'à une valeur finale de phase de courant de crête ; dans lequel la phase de courant de crête (22) est suivie par une phase de courant de maintien (23) dans laquelle le courant diminue jusqu'à une plage de valeurs de courant de maintien et y reste ; et dans lequel la phase de courant de maintien (23) est suivie par une phase de suppression progressive (24) dans laquelle le courant augmente d'une valeur de courant de début de phase de suppression à une valeur de courant intermédiaire de phase de suppression et diminue de la valeur de courant intermédiaire de phase de suppression à une valeur de courant de fin de phase de suppression ;

et **en ce qu'**un segment d'évaluation se trouve dans la phase d'augmentation de courant (21) ;

dans lequel la valeur du courant de fin de segment est inférieure à une valeur de courant maximale et est antérieure à la fin de la phase d'augmentation de courant (21) ; et dans lequel la valeur de courant de début de segment est donnée à un moment d'écart déterminé par les sous-étapes suivantes :

- formation d'une fonction logarithmique du courant mesuré dans la phase d'augmentation de courant (21) ;
- approximation de la fonction logarithmique représentant un segment temporel partiel antérieur inactif par une fonction linéaire ;
- détermination en continu d'une différence entre la fonction logarithmique et la fonction linéaire sur le segment temporel partiel antérieur inactif ; et

détermination du moment d'écart en fonction du moment où la différence atteint une mesure de différence prédéfinie.

2. Procédé selon la revendication 1, **caractérisé en ce que** le produit d'évaluation représente une superficie d'une surface sur un graphe de fonction du courant qui se modifie dans le temps, la surface étant délimitée au moins par un point du graphe de fonction associé à la valeur de courant de début de segment et par un point du graphe de fonction associé à la valeur de courant de fin de segment.

3. Procédé selon la revendication 2, **caractérisé en ce que** la surface est délimitée par une première ligne droite (61) passant par le point du graphe de fonction associé à la valeur de courant de début de segment qui est parallèle à un axe du temps ou parallèle à un axe du courant ; et **en ce que** la surface est délimitée par une deuxième ligne droite (62) passant par le point du graphe de fonction associé à la valeur de courant de fin de segment, qui est parallèle à un axe du temps ou parallèle à un axe du courant.

4. Procédé selon la revendication 2 ou 3, **caractérisé en ce que** la surface est en outre délimitée par la partie du graphe de fonction associée au segment d'évaluation.

5. Procédé selon la revendication 2 ou 3, **caractérisé en ce qu'**une partie du graphe de fonction associé au segment d'évaluation est approchée dans un premier segment d'évaluation par une troisième ligne droite (63) ; et **en ce que** la partie du graphe de fonction associée au segment d'évaluation est approchée dans un second segment d'évaluation par une quatrième ligne droite (64) ; dans lequel la surface est formée par un quadrilatère dont les côtés sont formés par la première ligne droite (61), par la deuxième ligne droite (62), par la troisième ligne droite (63) et par la quatrième ligne droite (64).

6. Procédé selon l'une des revendications 1 à 5, **caractérisé en ce qu'**un autre segment d'évaluation se situe dans la phase de courant de crête (22), la valeur de courant de fin de segment étant supérieure à la valeur intermédiaire de phase de courant de crête et étant atteinte dans le temps avant la valeur intermédiaire de phase de courant de crête.

7. Procédé selon l'une des revendications 1 à 6, **caractérisé en ce qu'**un autre segment d'évaluation se situe dans la phase de suppression progressive (24), la valeur de courant de phase de suppression étant utilisée comme valeur de courant de début de segment et la valeur de courant de fin de segment étant inférieure à la valeur intermédiaire de phase de courant de suppression et étant atteinte dans le temps avant la valeur intermédiaire de phase de suppression.

8. Unité de commande (12) pour commander et surveiller un actionneur électromagnétique conçu pour mettre en œuvre un procédé selon l'une des revendications 1 à 7.

Fig. 1

Fig. 2

Fig. 3

Fig. 4

Fig. 5

Fig. 6

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20110163769 A1
- US 20050146408 A1
- DE 102013213329 A1
- DE 102014203686 A1